# EUROPÄISCHE PATENTSCHRIFT

(11) **EP 1 436 827 B1**
(45) Veröffentlichungstag und Bekanntmachung des Hinweises auf die Patenterteilung: **25.05.2011**
(21) Anmeldenummer: 02772067.1
(22) Anmeldetag: 19.09.2002
(51) Int. Cl.: H01L 21/60, H01L 21/603, B23K 1/00, H01L 21/00

(54) **VORRICHTUNG ZUM VERLÖTEN VON KONTAKTEN AUF HALBLEITERCHIPS**
DEVICE FOR SOLDERING CONTACTS ON SEMICONDUCTOR CHIPS
DISPOSITIF POUR BRASER DES CONTACTS SUR DES PUCES SEMI-CONDUCTRICES

(30) Priorität: 27.09.2001 DE 10147789
(43) Veröffentlichungstag der Anmeldung: 14.07.2004
(73) Patentinhaber: Kulicke & Soffa Die Bonding GmbH, 8572 Berg TG (CH)
(72) Erfinder: BERGMANN, Robert, 93055 Regensburg (DE); HÜBNER, Holger, 85598 Baldham (DE)
(86) Internationale Anmeldenummer: PCT/DE2002/003506
(87) Internationale Veröffentlichungsnummer: WO 2003/030246

(56) Entgegenhaltungen:
- DE-A- 19 747 846
- DE-A- 19 907 276
- GB-A- 2 244 374
- US-A- 3 864 728
- US-A- 4 320 865
- US-A- 5 302 801
- US-A- 5 897 341
- US-B1- 6 265 244

## Beschreibung

Die vorliegende Erfindung betrifft eine Vorrichtung zum Verlöten von Kontakten insbesondere auf vertikal integrierten Halbleiterchips.

Bei der dreidimensionalen Integration von Halbleiterchips werden mehrere Ebenen gedünnter Chips aufeinander justiert und elektrisch verbunden. Die Bestückung erfolgt in einem Bestückungsautomaten, in dem die vereinzelten Chips auf einen Wafer justiert platziert werden. Die Oberflächen des Wafers und der Chips besitzen spiegelbildlich zueinander mit Kontaktflächen strukturierte Oberflächen, so dass die einander zugehörigen Kontakte mit hoher Genauigkeit aufeinander passend angebracht werden können. Die Oberfläche des Wafers besteht z. B. aus blankem Kupfer, die der Chips z. B. aus Zinn oder einer niedrig schmelzenden Zinnlegierung. Bei diesem Prozess tritt das Problem auf, dass die blanken Metalloberflächen, insbesondere die Kupferoberfläche, wegen der hohen Prozesstemperaturen oxidieren. Eine Oxidationsschicht verhindert aber ein zuverlässiges Kontaktieren.

Lötverfahren zum Weichlöten von Kupferoberflächen mit Loten auf Blei-Zinn-Basis sind bekannt und arbeiten sehr zuverlässig. Dabei liegen die Lotschichtdicken im Bereich von 100 µm. Die Oberflächen werden während der Erwärmung mit Formiergas gespült, dessen reaktiv wirkender Anteil die Oxidation verhindert. Eine Löttechnik, die unter den Bezeichnungen "isotherme Erstarrung" oder SOLID bekannt ist, verwendet äußerst dünne Lotschichten von weniger als 5 µm Dicke. Bei diesem Lötverfahren kommt es während des Lötvorgangs zum vollständigen Legieren des Lotmetalles mit den angrenzenden Metallflächen unter Bildung von intermetallischen Phasen, wodurch der Schmelzpunkt steigt und die Lotschmelze isotherm erstarrt. Während dünne Oxidschichten bei Verwendung einer dickeren Lotschicht aufbrechen können, so dass eine ausreichend gute Kontaktierung herstellbar ist, wird die Benetzung der Metalloberfläche mit einer sehr dünnen Schicht aus dem Lotmaterial auch durch eine dünne Oxidschicht bereits vollständig verhindert.

Es kommt daher bei dem SOLID-Lötverfahren, besonders darauf an, dass die Metallflächen, die miteinander verlötet werden, vollständig frei von Oxid bleiben. Es muss daher erreicht werden, dass während der Erwärmung möglichst wenig Luftsauerstoff in die den Wafer umgebende Atmosphäre aus Formiergas gelangt. Dazu muss das Formiergas den zu erhitzenden Chipbereich möglichst dicht umschließen. Das kann allerdings nicht vollständig erfolgen, da während der Justage beide Oberflächen frei zugänglich sein müssen.

In der GB 2244374 A ist eine Vorrichtung zum Verlöten von Kontakten auf vertikal integrierten Halbleiterchips beschrieben, bei der eine Spannvorrichtung, eine Spülvorrichtung, eine Chiphalterung und eine Heizung vorhanden sind. Aus der DE 198 50 595 A1 und der DE 195 04 967 A1 sind Verfahren zur Herstellung von Chip-Träger-Verbindungen bekannt, bei denen die Lotstellen von der Chiprückseite her erwärmt werden.

Aus der DE 197 47 846 A1 war ein Verfahren zur Kontaktierung von Bauelementen, insbesondere zur Verbindung eines Halbleiterchips mit einem Leiterrahmen, bekannt, bei dem die isotherme Erstarrung eingesetzt wird. Ein Siliziumchip kann mit einem Siliziumsubstrat auf die beschriebene Weise verbunden werden. Die Verbindung der auf den Teilelementen aufgebrachten Kontakte geschieht mittels einer Zwischenschicht, die durch Zuführen von Vibrationsenergie geschmolzen wird und durch isotherme Erstarrung die Verbindung herstellt. Thermische Unterstützung dieses Vorganges kann vorgesehen sein, da die Reaktion zweckmäßig bei erhöhter Temperatur unter Inertgas durchgeführt wird.

Aus der US-A-4-320865 ist eine Vorrichtung zum Verlöten von Kontakten auf Halbleiterbauelementen bekannt, mit einer Spannvorrichtung, einer Spülvorrichtung, einer Chiphalterung und einer Heizung.

Aufgabe der Erfindung ist es, eine Vorrichtung und ein Verfahren zum Verlöten von Kontakten auf Halbleiterchips anzugeben, mit dem sich äußerst dünne Metallflächen an Luft bei ca. 300°C miteinander verlöten lassen, ohne dass es während der Erhitzung zu einer Oxidation kommt, die die Herstellung einer dauerhaften elektrisch leitenden Verbindung verhindert. Insbesondere soll auch verhindert werden, dass benachbart zu den zu verlötenden Metallflächen vorhandene ungeschützte Flächen oxidieren.

Diese Aufgabe wird der Vorrichtung mit den Merkmalen des Anspruches 1 bzw. mit dem Verfahren mit den Merkmalen des Anspruches 9 gelöst. Ausgestaltungen ergeben sich aus den abhängigen Ansprüchen.

Die erfindungsgemäße Vorrichtung ist mit einer Heizung versehen, die so ausgestaltet ist, dass ein an einer Chiphalterung über einer Spannvorrichtung (chuck) eines Bestückungsautomaten gehaltener Chip von einer der Chiphalterung zugewandten Seite des Chips her zumindest so stark erwärmt werden kann, dass ein auf der der Spannvorrichtung zugewandten gegenüberliegenden Seite des Chips aufgebrachtes Lot geschmolzen wird. Außerdem ist eine Spülvorrichtung vorhanden, die eine Platte mit einem Fenster, einem Gaskanal für ein Formiergas und eine bei dem Fenster angeordnete Gasauslassöffnung aufweist. Diese Platte ist parallel zu der für den Wafer vorgesehenen Transportfläche ausgerichtet über der Spannvorrichtung angebracht. Die Chiphalterung ist vertikal zu der Transportfläche der Spannvorrichtung beweglich, so dass der Chip einem auf der Transportfläche angeordneten Wafer beliebig angenähert und insbesondere mit einem vorgesehenen oder einstellbaren Anpressdruck auf den Wafer aufgepresst werden kann.

Mit dieser Vorrichtung lässt sich auch das erfindungsgemäße Verfahren durchführen, bei dem auf den Kontakt des Chips ein Lot aufgebracht wird, die Kontakte mit einem Formiergas gespült werden, das Lot geschmolzen wird, indem der Chip von einer von dem Kontakt abgewandten Seite her erwärmt wird, bis das geschmolzene Lot eine Schicht einer Dicke von weniger als 5 µm bildet, die Kontakte aufeinander gepresst werden und das Lot so abgekühlt wird, dass es eine isotherme Erstarrung erfährt.

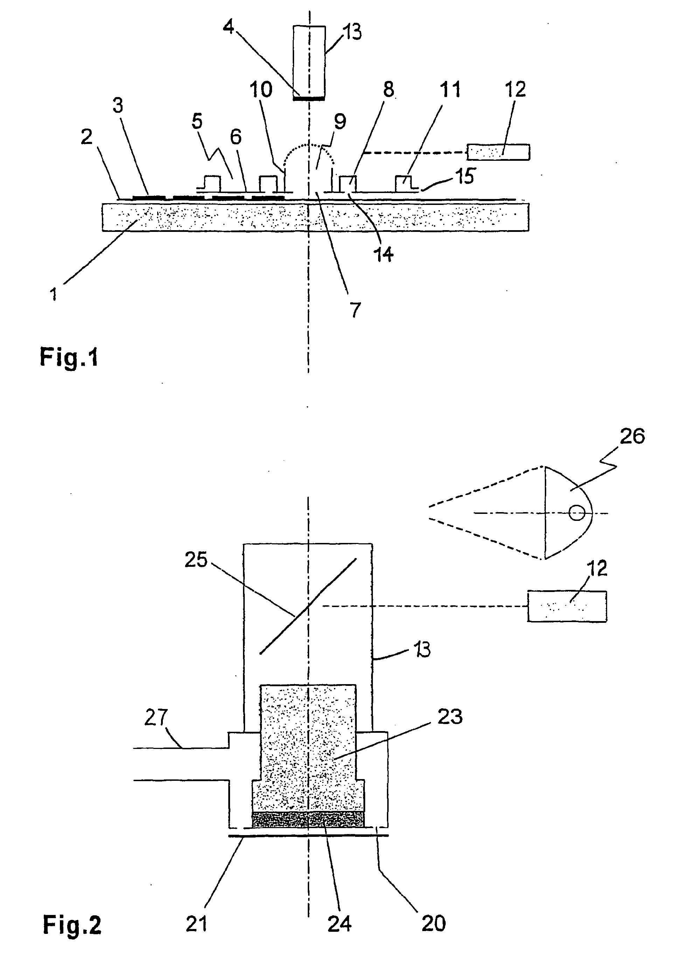

Es folgt eine Beschreibung eines bevorzugten Ausführungsbeispiels der erfindungsgemäßen Vorrichtung, mit der auch das erfindungsgemäße Verfahren ausgeführt werden kann, anhand der Figuren 1 und 2.

Die Figur 1 zeigt ein Schema eines Beispiels der erfindungsgemäßen Vorrichtung im Querschnitt.

Die Figur 2 zeigt eine vergrößerte Darstellung der Chiphalterung mit den Wärmequellen im Schema.

In Figur 1 ist die Vorrichtung im Querschnitt dargestellt. In diesem Beispiel ist ein Bestückungsautomat mit einer üblicherweise als Chuck bezeichneten Spannvorrichtung 1 wiedergegeben, die an einer Transportfläche mit einer Transportvorrichtung zur Aufnahme und zum Transport eines Wafers 2, der mit den Halbleiterchips bestückt werden soll, versehen ist. Der Wafer wird mit der oxidfreien Kupferoberfläche nach oben auf dem Chuck positioniert. In Figur 1 sind bereits auf dem Wafer aufgelötete Chips 3 dargestellt sowie ein weiterer Chip 4, der in dem nächsten Arbeitsgang aufgelötet werden soll. Dieser Chip 4 wird an einer Chiphalterung 13 über den Wafer gebracht und z. B. unter einem Ansaugkanal der Chiphalterung durch einen in der Chiphalterung hervorgerufenen Unterdruck gehalten.

Über der Transportvorrichtung des Chucks ist eine Spülvorrichtung 5 angeordnet, die im Wesentlichen durch eine Platte 6 mit einem Fenster 7, einem Gaskanal 8 und einer bei dem Fenster angeordneten Gasauslassöffnung 14 gebildet wird. Diese Platte ist parallel zu der Transportfläche und dem dort angeordneten Wafer angebracht oder wird zumindest während des Bestückungsvorgangs in dieser Lage fixiert. Der Wafer wird unter dem Fenster 7 dieser Platte hindurch transportiert, so dass jeweils der unter dem Fenster 7 vorhandene Bereich des Wafers von oben durch das Fenster hindurch mit dem nächsten Chip 4 bestückt werden kann. Die Chiphalterung 13 braucht zu diesem Zweck nur in vertikaler Richtung bewegt zu werden.

Die Platte 6 ist möglichst nahe über der Oberfläche des Wafers positioniert. Die Gasauslassöffnung 14 befindet sich möglichst nahe bei dem Fenster, so dass ein durch den Gaskanal 14 zugeführtes Formiergas den zu bestückenden Bereich des Wafers direkt erreicht. Das Formiergas tritt bei der in Figur 1 dargestellten Ausführung hauptsächlich im Fenster 7 der Platte aus. Der restliche Anteil des Formiergases strömt in radialer Richtung zum äußeren Rand der Platte und verhindert das Ansaugen von Raumluft. Im Bereich oberhalb des Fensters bildet sich eine sauerstoffarme Wolke 9 aus Formiergas aus, die in der Zeichnung mit einer gebogenen punktierten Linie angedeutet ist. Die Ausbildung dieses sauerstoffarmen Raumbereichs kann durch eine zusätzlich angebrachte ringförmige Blende 10 begünstigt werden, an deren oberem Rand das Gas bei Bedarf eventuell auch abgesaugt werden kann.

Am Rand der Platte 6 befindet sich vorzugsweise ein weiterer Gaskanal 11, über den Kühlluft zugeführt werden kann, die den Wafer in nach außen weisender radialer Richtung durch die entsprechend angeordnete weitere Gasauslassöffnung 15 anbläst. Die weitere Gasauslassöffnung 15 ist z. B. durch mehrere ringsum an dem Rand der Platte angebrachte Düsen gebildet, die nach außen gerichtet sind, so dass die Luft parallel zur Oberfläche des Wafers nach außen austritt. Ein radialer Strom des Kühlgases ist einer direkten Ausrichtung des Gasstromes auf den Wafer bei weitem vorzuziehen. Mit einem radialen Gasstrom wird auch der radiale Fluss des Formiergases unter der Platte 6 begünstigt.

Wenn der aufzulötende Chip 4 durch eine vertikale Bewegung der Chiphalterung 13 nach unten auf den Wafer 2 abgesenkt wird, taucht er in die sauerstoffarme Wolke 9 ein. In dieser Position kommt die Chiphalterung 13 in den Bereich der Einkopplung einer Wärmestrahlungsquelle 12, die in diesem Ausführungsbeispiel durch eine Laserstrahlungsquelle gebildet ist. Damit wird der Chip 4 von seiner von dem Wafer abgewandten Rückseite her so stark erwärmt, dass das Lotmaterial auf der Vorderseite schmilzt und so die Kontaktverbindung zu der Kupferoberfläche des Wafers hergestellt werden kann.

Es ist günstig, wenn die niedrig schmelzende Lotschicht auf den Kontakten des Chips 4 und nicht auf den damit zu verlötenden Kontakten des Wafers aufgebracht ist, da so ein besserer Wärmekontakt durch den Chip hindurch zur Lotschicht erreicht wird. Die Erwärmung des Chips führt auf diese Weise unverzüglich zum Aufschmelzen des Lotmaterials, das sich beim Kontakt mit der kälteren Kupferschicht des Wafers in einem Bruchteil einer Sekunde verfestigt.

In der Figur 2 ist im Querschnitt ein Ausführungsbeispiel der Chiphalterung 13 gezeigt. Eine untere plane Fläche zur Aufnahme des Chips 21 besitzt am Rand ringsum Öffnungen 20, die mit einem Kanal verbunden sind. Damit wird der Chip 21 angesaugt. Ein Ansaugstutzen 27 ist zu diesem Zweck mit einer geeigneten Pumpe oder einer anderen Vorrichtung zur Erzeugung eines Unterdruckes verbunden. Innerhalb der Chiphalterung ist ein für Infrarotstrahlung durchlässiger Körper 23 angebracht. Durch diesen Körper hindurch kann die Wärmestrahlung die Rückseite des angesaugten Chips erreichen. Der Körper 23, der z. B. aus Quarzglas sein kann, ist außerdem geeignet, den mechanischen Anpressdruck von typisch 3,5 bar auf den Chip zu übertragen. Um die Kraft möglichst gleichmäßig auf den Chip zu übertragen, kann eine zusätzliche, ebenfalls infrarotdurchlässige, vorzugsweise elastische und temperaturbeständige Schicht 24 vorgesehen werden, die z. B. Silikon sein kann. Die Einkopplung der Wärmestrahlung erfolgt in diesem Beispiel über einen in der Chiphalterung 13 schräg angebrachten metallischen Spiegel 25 oder über ein metallisch verspiegeltes Prisma, das die Wärmestrahlung zum Chip hin reflektiert. Ein solches Prisma kann auch in den Körper 23 integriert sein.

Die Homogenität der Temperaturverteilung über die Chipfläche ist grundsätzlich nicht kritisch. Es muss nur dafür gesorgt werden, dass überall auf den Kontakten die Schmelztemperatur des Lotmateriales überschritten wird. Eine möglichst gleichmäßige Ausleuchtung der Chipfläche mit der Wärmestrahlung wird im Interesse einer kurzen Aufwärmzeit angestrebt.

Die maximal zulässige Temperatur ist andererseits nur durch die verwendeten Materialien begrenzt. Grundsätzlich ist es daher ausreichend, wenn nur ein Punkt, der bevorzugt in der Mitte des Chips liegt, erwärmt wird. Zweckmäßigerweise wird dann einen Moment abgewartet, bevor der warme Chip mit dem kalten Wafer in Kontakt gebracht wird. Dadurch wird vermieden, dass das Lotmaterial vorzeitig abgekühlt wird, bevor sich die Wärme lateral ausreichend verteilen konnte.

Falls die Wärme nicht nur auf einen Punkt eingestrahlt werden soll, kann durch einen Diffusor oder eine geeignete Optik erreicht werden, dass die Wärmestrahlung, z. B. der Laserstrahl, in geeigneter Weise so aufgeweitet wird, dass die gesamte Chipfläche davon erfasst wird. Alternativ kann die Wärmestrahlung in einen Lichtleiter eingekoppelt werden, der an die Chiphalterung 13 angekoppelt ist und die Wärmestrahlung auf den Chip leitet. Ein solcher Lichtleiter kann den Spiegel 25 oder das Prisma und den Körper 23 ersetzen. Als Wärmequelle kann auch eine Halogenlampe 26 mit Parabolspiegel statt der Laserstrahlungsquelle 12 benutzt werden. Das ist in Figur 2 durch eine alternative Zeichnung wiedergegeben.

Im Fall besonders kleiner Chips mit nur wenig mm² Fläche kann die dann entsprechend klein ausgestaltete Chiphalterung von außen angestrahlt und insgesamt erhitzt werden. Möglich ist auch eine Aufwärmung einer zumindest teilweise metallisch ausgebildeten Chiphalterung mittels einer Heizwicklung, mit der in dem Metall ein Wirbelstrom induktiv erzeugt wird, oder auch eine direkte Erwärmung der Lotschicht, indem die Wirbelströme direkt in der Lotschicht hervorgerufen werden.

Die für die Aufnahme eines Chips vorgesehene untere Fläche der Chiphalterung kann aus einem Material bestehen, das eine ausreichende Elastizität besitzt, um laterale Bewegungen des Chips im Bereich von typisch +/- 10 µm zu ermöglichen. Damit wird aufgrund der Oberflächenspannung der geschmolzenen Lotschicht eine Selbstzentrierung der beiden spiegelbildlich zueinander strukturierten Kontaktflächen erreicht.

## Patentansprüche

1. Vorrichtung zum Verlöten von Kontakten auf vertikal integrierten Halbleiterchips, bei der
eine Spannvorrichtung (1),
eine Spülvorrichtung (5),
eine Chiphalterung (13) und
eine Heizung vorhanden sind,
wobei
- die Spannvorrichtung (1) dafür vorgesehen ist, einen Wafer (2) mit Bauelementen aufzunehmen und zu transportieren,
- die Spülvorrichtung (5) eine Platte (6) mit einem Fenster (7), einem Gaskanal (8) und einer bei dem Fenster angeordneten Gasauslassöffnung (14) aufweist, wobei diese Platte parallel zu einer für den Wafer vorgesehenen Transportfläche der Spannvorrichtung (1) ausgerichtet ist und in dieser Lage über der Spannvorrichtung (1) gehalten wird,
- die Chiphalterung (13) über der Spannvorrichtung (1) über dem Fenster (7) angeordnet ist, so dass ein Chip (4) auf einer der Spannvorrichtung (1) zugewandten Seite der Chiphalterung über einem Wafer (2) gehalten werden kann und mittels einer bezüglich des Wafers vertikalen Bewegung der Chiphalterung dem Wafer beliebig dicht angenähert werden kann, und
- die Heizung so ausgestaltet ist, dass ein an der Chiphalterung (13) gehaltener Chip (4) von einer der Chiphalterung zugewandten Seite des Chips her zumindest so stark erwärmt werden kann, dass ein auf einer gegenüberliegenden Seite des Chips aufgebrachtes Lot geschmolzen wird.

2. Vorrichtung nach Anspruch 1, bei der
die Gasauslassöffnung (14) rings um das Fenster (7) vorhanden ist.

3. Vorrichtung nach Anspruch 1 oder 2, bei der ein von dem Fenster (7) abgewandter Rand der Platte (6) mit einem weiteren Gaskanal (11) und einer weiteren Gasauslassöffnung (15) versehen ist, die in einer Richtung innerhalb einer flächigen Ausdehnung der Platte von der Platte weg weist.

4. Vorrichtung nach einem Ansprüche 1 bis 3, bei der die Heizung eine Wärmestrahlungsquelle (12, 26) umfasst, die so angeordnet ist, dass eine davon ausgesandte Wärmestrahlung durch die Chiphalterung (13) auf den Chip (21) gelenkt wird.

5. Vorrichtung nach Anspruch 4, bei der
in der Chiphalterung (13) ein für Infrarotstrahlung durchlässiger Körper (23) angebracht ist, mit dem ein Anpressdruck auf den Chip (21) übertragen wird.

6. Vorrichtung nach einem der Ansprüche 1 bis 3, bei der die Heizung eine Induktionsspule mit elektrischen Anschlüssen umfasst und
diese Induktionsspule in der Chiphalterung (13) angebracht ist.

7. Vorrichtung nach Anspruch 6, bei der
in der Chiphalterung (13) ein elektrisch leitender Körper angebracht und so angeordnet ist, dass er durch eine Induktion von Wirbelströmen mittels der Induktionsspule erwärmt werden kann.

8. Vorrichtung nach Anspruch 6, bei der
die Induktionsspule so angeordnet ist, dass mittels der Induktionsspule in dem auf einem an der Chiphalterung (13) gehaltenen Chip (21) aufgebrachten Lot Wirbelströme induziert werden können, mit denen das Lot geschmolzen wird.

9. Verfahren zum Verlöten von Kontakten auf vertikal integrierten Halbleiterchips, bei dem
ein Kontakt eines Chips auf einen Kontakt eines Bauelementes in einem Wafer gelötet wird, indem
- auf den Kontakt des Chips ein Lot aufgebracht wird,
- die Kontakte mit einem Formiergas gespült werden,
das Lot geschmolzen wird,
die Kontakte aufeinander gepresst werden und
das Lot bis zur Erstarrung abgekühlt wird,
worin das Lot geschmolzen wird, indem der Chip von einer von dem Kontakt abgewandten Seite her erwärmt wird,
das Lot so aufgebracht wird, dass es in geschmolzenem Zustand auf dem Kontakt eine Schicht einer Dicke von weniger als 5 µm bildet, und
das Lot so abgekühlt wird, dass es eine isotherme Erstarrung erfährt.

10. Verfahren nach Anspruch 9, bei dem
der Chip unter Verwendung einer Wärmestrahlungsquelle erwärmt wird.

## Claims

1. A device for soldering contacts on vertically integrated semiconductor chips, comprising
a clamping device (1),
a flushing device (5),
a chip mount (13), and
a heater, wherein
• the clamping device (1) is configured to receive and transport a wafer (2) having components;
• the flushing device (5) includes a plate (6) with a window (7), a gas channel and a gas outlet opening (14) arranged at the window, the plate (6) being aligned parallel to a transporting area of the clamping device (1) intended for the wafer (2) to be held in position above the clamping device (1);
• the chip mount (13) is arranged above the clamping device (1) over the window (7) such that a chip can be held on a side of the chip mount (13) facing the clamping device (1) and over the wafer (2), and the chip (4) can be brought arbitrarily close to the wafer (2) by means of a vertical movement of the chip mount (13) with respect to the wafer (2); and
• the heater is configured to heat a chip (4) held on the chip mount (13) from a side of the chip (4) facing the chip mount (13) at least to a degree that a solder applied to an opposite side of the chip (4) is melted.

2. The device according to claim 1, wherein the first gas outlet opening (14) is provided around the window (7).

3. The device according to claim 1 or 2, wherein an edge of the plate (6) facing away from the window (7) is provided with an additional gas channel (11) and an additional gas outlet opening (15), which points away from the plate in a direction within a two-dimensional extent of the plate.

4. The device according to one of claims 1 through 3, wherein the heater comprises a thermal radiation source (12, 26), which is arranged in such a way that thermal radiation emitted by the thermal radiation source is directed through the chip mount (13) onto the chip (21) .

5. The device according to claim 4, further comprising a body (23) which is permeable to infrared radiation and with which a pressing pressure is transferred to the chip (21) is fitted in the chip mount (13).

6. The device according to one of claims 1 through 3, wherein the heater comprises an induction coil having electrical terminals and is fitted in the chip mount (13).

7. The device according to claim 6, further comprising an electrically conducting body fitted in the chip mount (13) and arranged in such a way that the electrically conducting body can be heated by an induction of eddy currents by means of the induction coil.

8. The device according to claim 6, wherein the induction coil is arranged such that the induction coil induces eddy currents in the solder applied to the chip (21) held on the chip mount (13), with which currents the solder is melted.

9. A method for soldering contacts on vertically integrated semiconductor chips such that a contact of a chip is soldered onto a contact of a component in a wafer, wherein
solder is applied to the contact of the chip;
the contacts are flushed with a forming gas;
the solder is melted,
the contacts are pressed onto one another, and
the solder is cooled until it solidifies, wherein
the solder is melted by heating the chip from a side facing away from the contact,
the solder is applied such that in a molten state it forms a layer of a thickness of less than 5 µm on the contact, and
the solder is cooled such that it undergoes an isothermal solidification.

10. The method according to claim 9, wherein the chip is heated using a thermal radiation source.

## Revendications

1. Dispositif de brasage de contacts sur des puces de semiconducteurs intégrées verticalement, dans lequel un dispositif de serrage (1),
un dispositif de rinçage (5),
un support de puce (13) et
un dispositif de chauffage sont présents,
dans lequel
- le dispositif de serrage (1) est prévu pour recevoir et transporter une tranche (2) avec des composants,
- le dispositif de rinçage (5) présente une plaque (6) avec une fenêtre (7), un canal de gaz (8) et une ouverture d'échappement de gaz (14) disposée près de la fenêtre, dans lequel cette plaque est alignée parallèlement à une surface de transport du dispositif de serrage (1) prévue pour la tranche et est maintenue dans cette position par l'intermédiaire du dispositif de serrage (1),
- le support de puce (13) est disposé par l'intermédiaire du dispositif de serrage (1) par-dessus la fenêtre (7), de sorte qu'une puce (4) puisse être maintenue par-dessus une tranche (2) sur un côté du support de puce tourné vers le dispositif de serrage (1) et puisse être rapprochée de la tranche de manière étanche au choix au moyen d'un mouvement vertical du support de puce par rapport à la tranche, et
- le dispositif de chauffage est réalisé de telle sorte qu'une puce (4) maintenue sur le support de puce (13) puisse être chauffée par un côté tourné vers le support de puce de la puce au moins assez intensément pour qu'un métal d'apport de brasage appliqué sur un côté en vis-à-vis de la puce soit fondu.

2. Dispositif selon la revendication 1, dans lequel
l'ouverture d'échappement de gaz (14) est présente sous une forme encerclant la fenêtre (7).

3. Dispositif selon la revendication 1 ou 2, dans laquelle
un bord de la plaque (6) se détournant de la fenêtre (7) est pourvu d'un canal de gaz (11) supplémentaire et d'une ouverture d'échappement de gaz (15) supplémentaire, qui se détourne de la plaque dans une direction à l'intérieur d'une dilatation à plat de la plaque.

4. Dispositif selon une des revendications 1 à 3, dans lequel
le dispositif de chauffage comprend une source de rayonnement thermique (12, 26), qui est disposée de telle sorte qu'un rayonnement thermique émis par celle-ci soit dirigé sur la puce (21) à travers le support de puce (13).

5. Dispositif selon la revendication 4, dans lequel
dans le support de puce (13) est monté un corps (23) perméable au rayonnement infrarouge, avec lequel une pression de pressage est transmise sur la puce (21).

6. Dispositif selon une des revendications 1 à 3, dans lequel
le dispositif de chauffage comprend une bobine d'induction avec des connexions électriques et cette bobine d'induction est montée dans le support de puce (13).

7. Dispositif selon la revendication 6, dans lequel
dans le support de puce (13) un corps électriquement conducteur est monté et disposé de telle sorte qu'il puisse être chauffé par une induction de courants de Foucault au moyen de la bobine d'induction.

8. Dispositif selon la revendication 6, dans lequel
la bobine d'induction est disposée de telle sorte que au moyen de la bobine d'induction des courants de Foucault puissent être induits dans le métal d'apport de brasage appliqué sur une puce (21) maintenue sur le support de puce (13), avec lesquels le métal d'apport de brasage est fondu.

9. Procédé de brasage de contacts sur des puces de semiconducteurs intégrées verticalement, dans lequel
un contact d'une puce sur un contact d'un composant est brasé dans une tranche, en ce que
- un métal d'apport de brasage est appliqué sur le contact de la puce,
- les contacts sont rincés avec un mélange hydrogène - azote,
le métal d'apport de brasage est fondu les contacts sont pressés les uns sur les autres et
le métal d'apport de brasage est refroidi jusqu'à la solidification,
dans lequel
le métal d'apport de brasage est fondu, en ce que la puce est chauffée par un côté se détournant du contact,
le métal d'apport de brasage est appliqué de telle sorte que dans l'état fondu une couche d'une épaisseur inférieure à 5 µm se forme sur le contact, et
le métal d'apport de brasage est refroidi de telle sorte qu'il subisse une solidification isotherme.

10. Procédé selon la revendication 9, dans lequel
la puce est chauffée en employant une source de rayonnement thermique.
